# EUROPÄISCHE PATENTSCHRIFT

(11) **EP 0 792 092 B1**
(45) Veröffentlichungstag und Bekanntmachung des Hinweises auf die Patenterteilung: **12.12.2007**
(21) Anmeldenummer: 96117583.3
(22) Anmeldetag: 02.11.1996
(51) Int. Cl.: H05K 3/00, H05K 7/20

(54) **Verfahren zur Herstellung einer Verbundanordnung**
Process for manufacturing a composite arrangement
Procédé de fabrication d'un agencement composite

(30) Priorität: 24.02.1996 DE 19607014
(43) Veröffentlichungstag der Anmeldung: 27.08.1997
(73) Patentinhaber: ROBERT BOSCH GMBH, 70442 Stuttgart (DE)
(72) Erfinder: Wagenbrenner, Walter, 71732 Tamm (DE); Wiesa, Thomas, 71665 Vaihingen (DE); Schimitzek, Ralph, 74248 Ellhofen (DE)

(56) Entgegenhaltungen:
- DE-A- 4 307 134
- GB-A- 2 153 595
- PATENT ABSTRACTS OF JAPAN vol. 16, no. 255 (E-1214), 10.Juni 1992 & JP 04 056187 A (MITSUBISHI ELECTRIC CORP), 24.Februar 1992,
- PATENT ABSTRACTS OF JAPAN vol. 17, no. 115 (E-1330), 10.März 1993 & JP 04 296084 A (YAMASHITA SAAKITETSUKU KK), 20.Oktober 1992,
- PATENT ABSTRACTS OF JAPAN vol. 16, no. 539 (E-1289), 10.November 1992 & JP 04 206675 A (NIPPON AVIONICS CO), 28.Juli 1992,

## Beschreibung

### Stand der Technik

Die Erfindung betrifft ein Verfahren zur Herstellung einer Verbundanordnung, wobei wenigstens ein Leiterplattensubstrat unter der Einwirkung eines durch einen Preßstempel ausgeübten Preßdrucks über eine mit Harz getränkte Gewebeschicht (prepreg) mit einem Träger verbunden wird.

Ein Verfahren zur Verbindung von mit elektronischen Bauelementen bestückten Schaltungsanordnungen, beispielsweise Leiterplatten oder Hybridelementen, mit einem Träger, geht beispielsweise aus der DE 42 40 996 C1 hervor.

Aus der GB 2153595 A ist des Weiteren eine Leiterplatte 20 bekannt, die mittels eines "prepreg" oder einer anderen Klebeschicht mit einer Metallplatte verbunden ist. Die Leiterplatte weist Durchgangslöcher auf, die über die Materialstärke der Leiterplatten vollständig verläuft. Das "prepreg" bzw. die Klebeschicht ist an dieser Stelle nicht gelocht; jenseits der Durchgangslöcher in den Leiterplatten erstreckt sich fluchtend mit diesen Durchgangslöchern in der Metallplatte jeweils eines weiteres Durchgangsloch, das über die Materialstärke der Metallplatte verläuft. Bei dem in der genannten Schrift dargestellten Stand der Technik ist nachteilig, dass beim Verkleben der Leiterplatte mit der Kühlplatte mittels der Klebeschicht Klebstoff in das Durchgangsloch der Leiterplatte fließen kann. Auch hier kann sich beim Pressvorgang verflüssigendes Harz undefiniert in diese Durchgangsbohrung bewegen, so dass im Extremfall bestimmte Durchgangslöcher nicht für die Verbindung mit Anschlussbeinchen mittels Löten geeignet sind, da die Anschlussbeinchen die Durchgangslöcher nicht belegen können, weil bereits mit Harz gefüllt.

Der Erfindung liegt daher die Aufgabe zugrunde, ein Verfahren zur Herstellung einer Verbundanordnung der gattungsgemäßen Art derart zu verbessern, dass beim Verbinden des Leiterplatten-Substrats mit dem Träger kein Harz undefiniert in Bohrungen, Durchkontaktierungen u. dgl. fließen kann.

### Vorteile der Erfindung

Diese Aufgabe wird bei einem Verfahren zur Herstellung einer Verbundanordnung der eingangs beschriebenen Art erfindungsgemäß dadurch gelöst, dass einerseits im Bereich einer Öffnung eine Ausnehmung im Träger vorhanden ist und andererseits die Verbindung wenigstens eine in dem Leiterplattensubstrat und im Prepreg angeordnete Entlüftungsbohrung ist. Dies führt beispielsweise dazu, dass in die Öffnung eintretendes Harz in der Ausnehmung gesammelt wird und somit dieses Harz die Öffnung nicht unzulässig verschließen kann.

Hinsichtlich der Durchführung des Verfahrens sind die unterschiedlichsten Ausführungsarten denkbar.

Eine vorteilhafte Ausführung besteht jedoch darin, in dem Träger im Bereich der Öffnung eine Ausnehmung und eine Verbindung der Ausnehmung mit der Umgebung vorzusehen. Hierdurch wird bei der Herstellung der Verbundanordnung, d.h. des Leiterplatten-Verbundes das Leiterplatten-Substrat beim Verpressen mit einem geringeren Pressdruck auf die Leiterplatte aufgebracht. Dadurch wird auf einfache Weise vermieden, dass das Leiterplatten-Substrat im Bereich der Öffnung mit dem Träger verklebt. Auf diese Weise kann im Bereich der Öffnung demnach auch kein Harz entstehen, das in die Öffnung fließt. Die Verbindung mit der Umgebung ist insbesondere hinsichtlich eines späteren Lötvorgangs (Reflowlötung) bei einer hohen Temperatur nötig. In diesem Falle kommt es zu einer Ausdehnung der in der Ausnehmung zwischen dem Leiterplatten-Substrat und dem Träger eingeschlossenen Luft. Diese erwärmte Luft kann in vorteilhafter Weise durch die Verbindung in die Atmosphäre entweichen.

Die Verbindung selbst kann auf die unterschiedlichste Art und Weise hergestellt sein. So wäre beispielsweise eine Bohrung in dem Träger als Verbindung denkbar. Hinsichtlich einer schnellen Entweichung der erwärmten Luft auf kürzestem Wege ist jedoch eine in dem Leiterplatten-Substrat und in dem prepreg angeordnete Entlüftungsbohrung besonders vorteilhaft.

Eine andere, besonders vorteilhafte Durchführung des Verfahrens sieht vor, daß der Preßstempel im Bereich der Öffnung eine Aussparung aufweist.

Hierdurch wird im Bereich der Öffnung überhaupt kein Preßdruck auf das Leiterplattensubstrat und das unter diesem befindliche prepreg sowie auf den Träger ausgeübt, so daß es im Bereich der Öffnung durch diese Ausbildung des Preßstempels nicht zu einem Fließen des Harzes kommen kann und hierdurch auch ein Fließen in die Öffnung vermieden wird.

Eine wiederum andere vorteilhafte Durchführung des Verfahrens sieht vor, daß zwischen den Preßstempel und das Leiterplatten-Substrat eine Preßeinlage gelegt wird, die im Bereich der Öffnung eine Ausnehmung aufweist. Auch durch diese Ausnehmung in der Preßeinlage wird der auf das Substrat und damit das prepreg und den Träger ausgeübte Druck wesentlich bzw. vollständig vermindert.

Die Verwendung einer solchen, im Bereich der Öffnung mit einer Ausnehmung versehenen Preßeinlage kann insbesondere auch in Verbindung mit den oben beschriebenen Ausführungsarten des Verfahrens vorgesehen werden, da hierdurch ein Fließen des Harzes besonders wirkungsvoll unterdrückt wird.

Wird die Verwendung einer Preßeinlage in Verbindung mit der ersten Variante des Verfahrens, bei dem in dem Träger in dem Bereich der Öffnung eine Ausnehmung und eine Verbindung der Ausnehmung mit der Umgebung vorgesehen ist, kombiniert, ist die in der Grundplatte angeordnete Ausnehmung in vorteilhafter Weise an die Toleranzen des Leiterplatten-Substrats und an die in der Öffnung anzuordnenden Steckerpins, Anschlußdrähte u.dgl. angepaßt.

Eine weitere, besonders vorteilhafte Ausführungsart des Verfahrens verwendet einen Preßstempel, der im Bereich der Öffnung eine Aussparung aufweist und zusätzlich eine in der Grundplatte im Bereich der Öffnung, auf die Aussparung im Preßstempel angepaßte Ausnehmung und eine Verbindung der Ausnehmung mit der Umgebung. Durch diese Anordnung wird die Ausübung eines Preßdrucks im Bereich der Öffnung vollständig unterdrückt.

Eine weitere, besonders vorteilhafte Ausführungsart des Verfahrens sieht vor, daß zwischen den Preßstempel und das Leiterplatten-Substrat eine Preßeinlage gelegt wird und daß zusätzlich in der Grundplatte im Bereich der Öffnung eine auf die Aussparung in der Preßeinlage angepaßte Ausnehmung und eine Verbindung der Ausnehmung mit der Umgebung vorgesehen ist. Auch durch diese Anordnung wird der Preßdruck im Bereich der Öffnung besonders wirkungsvoll unterdrückt.

Insbesondere zu einer weiteren Verbesserung der beiden letztgenannten Ausführungsarten des Verfahrens ist vorgesehen, daß zusätzlich im Bereich der Öffnung auch in dem prepreg eine Aussparung vorgesehen ist. Hierdurch wird praktisch die vollständige Unterdrückung des Preßdrucks im Bereich der Öffnung erzielt.

### Zeichnung

Weitere Merkmale und Vorteile der Erfindung sind Gegenstand der nachfolgenden Beschreibung und werden anhand der zeichnerischen Darstellung näher erläutert.

In der Zeichnung zeigen:
- Fig. 1: eine geschnittene Darstellung einer mit Hilfe einer Ausführungsart des erfindungsgemäßen Verfahrens hergestellten Verbundanordnung;
- Fig. 2: eine Vorrichtung zur Durchführung einer anderen Ausführungsart des erfindungsgemäßen Verfahrens und

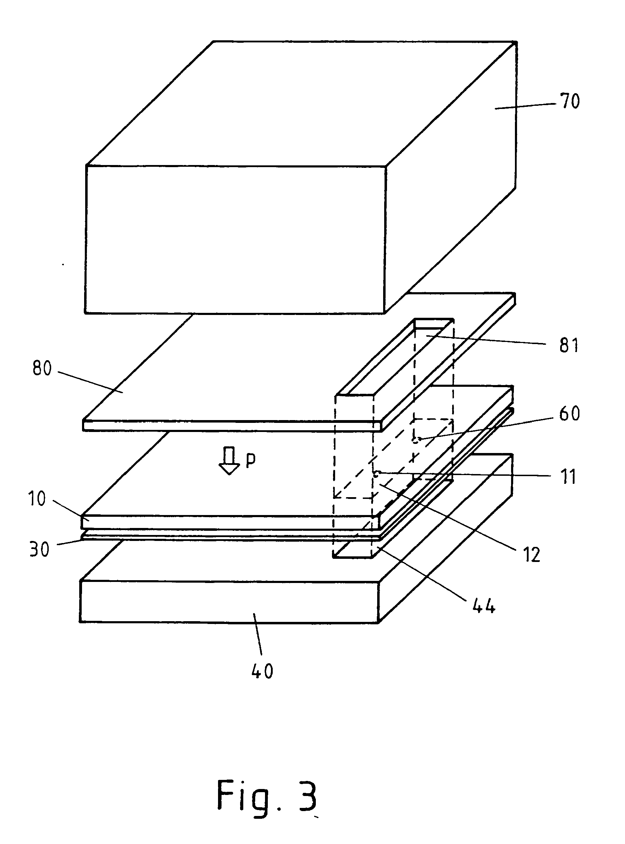

- Fig. 3: eine Vorrichtung zur Durchführung einer wiederum anderen Ausführungsart des erfindungsgemäßen Verfahrens.

### Beschreibung der Ausführungsbeispiele

Wie aus den Figuren hervorgeht, wird eine Verbundanordnung dadurch hergestellt, daß ein Leiterplatten-Substrat 10 unter der Einwirkung eines durch einen Preßstempel 20 ausgeübten Preßdrucks p über eine mit Harz getränkte Gewebeschicht, ein sogenanntes prepreg 30, mit einem Träger 40 verbunden wird. Gleichzeitig zu der Ausübung des Preßdrucks p kann über den Preßstempel 20 Wärme zugeführt werden.

Durch die Ausübung des Preßdrucks p auf das Leiterplatten-Substrat 10 fließt das Harz in dem prepreg 30 und stellt hierdurch eine Klebeverbindung zwischen dem Leiterplatten-Substrat 10 und dem Träger 40, der zumeist aus einem Metall, beispielsweise aus Aluminium, besteht, her.

Es versteht sich, daß das Verfahren nicht auf das Aufbringen eines Leiterplatten-Substrats 10 auf einen Träger 40 beschränkt ist, sondern daß vielmehr auf diese Weise auch mehrere Leiterplatten-Substrate 10 jeweils über ein prepreg 30 auf einem Träger 40 übereinanderliegend befestigt werden können.

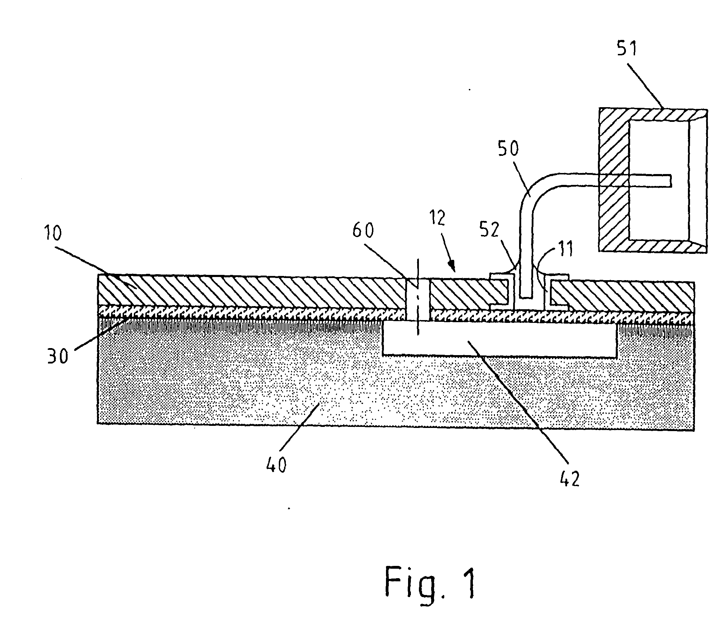

Um nun ein Fließen des Harzes in eine in dem Leiterplatten-Substrat 10 angeordnete Öffnung 11 zu verhindern, wird der Preßdruck p im Bereich 12 der Öffnung 11 vermindert bzw. vollständig entfernt. Dies geschieht beispielsweise dadurch, daß in dem Träger 40 eine Ausnehmung 42 vorgesehen ist, so daß in diesem Bereich über den Preßstempel 20 ein geringerer Preßdruck p ausgeübt wird, da dem Preßstempel 20 in diesem Bereich neben dem Leiterplatten-Substrat 10 und dem prepreg 30 keine Druckfläche gegenübersteht (vgl. insbesondere Fig. 1).

Hierdurch kommt es im Bereich 12 der Öffnung 11 nicht zu einem Fließen des Harzes und damit auch nicht zu einer Verstopfung der Öffnung 11. In diese Öffnung 11 kann, wie in Fig. 1 dargestellt, in einem späteren Verfahrensschritt ein Kontaktelement, beispielsweise ein Anschlußdraht 50 eines Steckers 51 mittels einer Reflowlötung durch eine Lötverbindung 52 mit dem Leiterplattensubstrat 10 verbunden werden.

Da bei dieser Ausführungsart des Verfahrens zur Herstellung einer Verbundanordnung aus Leiterplatten-Substrat 10 und Träger 40 in der Ausnehmung 42 Luft eingeschlossen wird und sich diese beim Lötvorgang erwärmt und dadurch ausdehnt, ist in dem Leiterplatten-Substrat 10 und in dem prepreg 30 eine Verbindung mit der Umgebung in Form einer Entlüftungsbohrung 60 vorgesehen, durch welche die erwärmte und sich ausdehnende Luft in der Ausnehmung 42 beim Anlöten des Verbindungsdrahts 50 entweichen kann.

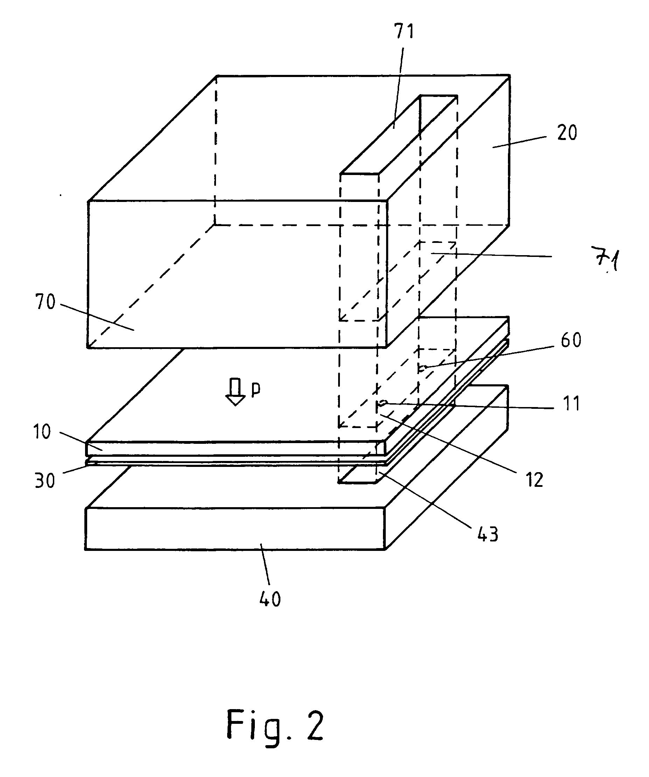

Der Druck p auf das Leiterplatten-Substrat 10 im Bereich 12 der Öffnung 11 kann auch dadurch vermindert werden, daß der Preßstempel 70 im Bereich 12 der Öffnung 11 eine Aussparung 71 aufweist, wie es in Fig. 2 schematisch dargestellt ist. Auch hierdurch wird vermieden, daß auf das Leiterplatten-Substrat 10 und über dieses auf das prepreg 30 ein Druck p ausgeübt wird und hierdurch das Harz in die Öffnung 11 fließt, diese verstopft und für eine spätere Weiterverarbeitung unzugänglich macht.

Darüber hinaus kann auch bei einer anderen Ausführungsform des Verfahrens zwischen dem Preßstempel 70 und das Leiterplatten-Substrat 10 eine Preßeinlage 80 gelegt werden, die im Bereich 12 der Öffnung 11 eine Ausnehmung 81 aufweist. Auch durch diese in der Preßeinlage 80 angeordnete Ausnehmung 81 wird vermieden, daß auf das Leiterplattensubstrat 10 im Bereich 12 der Öffnung 11 ein Preßdruck p ausgeübt wird, der zu einem unerwünschten Fließen des Harzes führt.

Zusätzlich zu der Öffnung 42 in dem Träger 40 kann in dem prepreg 30 im Bereich 12 der Öffnung 11 eine (nicht dargestellte) Aussparung vorgesehen sein.

In diesem Falle ist die in dem Träger 40 angeordnete Ausnehmung 42 auf die Toleranzen des Leiterplatten-Substrates 10 und die Toleranzen der in der Öffnung 11 anzuordnenden Steckerpins, Anschlußdrähte 50 u.dgl. angepaßt.

Eine besonders wirkungsvolle Ausführungsart des Verfahrens besteht darin, daß der Preßstempel 70 im Bereich der Öffnung eine Aussparung 71 aufweist und daß zusätzlich in dem Träger 40 im Bereich 12 der Öffnung 11 eine auf die Aussparung 71 in dem Preßstempel 70 angepaßte Ausnehmung 43 in dem Träger 40 und eine Verbindung dieser Ausnehmung 43 mit der Umgebung in Form einer Entlüftungsbohrung 60 vorgesehen sind (vergl. Fig. 2).

Eine andere, sehr wirkungsvolle Ausführungsart des Verfahrens sieht vor, daß zwischen dem Preßstempel 70 und dem Leiterplatten-Substrat 10 die Preßeinlage 80, die im Bereich der Öffnung 11 die Ausnehmung 81 aufweist, gelegt wird, und daß zusätzlich hierzu in der Grundplatte im Bereich 12 der Öffnung 11 eine Ausnehmung 44, die auf die Ausnehmung 81 in der Preßeinlage 80 angepaßt ist, und eine Verbindung der Ausnehmung 44 mit der Umgebung in Form der Entlüftungsbohrung 60 vorgesehen sind.

Zusätzlich kann hierbei auch noch jeweils in dem prepreg 30 eine Ausnehmung (nicht dargestellt) vorgesehen sein, die auf die entsprechenden Ausnehmungen 43, 44 in dem Träger 40 sowie auf die Aussparung 71 in dem Preßstempel 70 bzw. auf die Ausnehmung 81 in der Preßeinlage 80 angepaßt ist.

## Patentansprüche

1. Verfahren zur Herstellung einer Verbundanordnung, wobei wenigstens ein Leiterplatten-Substrat (10) unter der Einwirkung eines durch einen Preßstempel (70) ausgeübten Preßdrucks über eine mit Harz getränkte Gewebeschicht (prepreg, 30) mit einem Träger verbunden wird, wobei im Bereich (12) einer Öffnung (11) des Leiterplatten-Substrats (10) der Preßdruck (p) wenigstens teilweise vermindert wird und
in dem Träger (40) im Bereich (12) der Öffnung (11) eine Ausnehmung (42) und eine Verbindung der Ausnehmung (42) mit der Umgebung vorgesehen sind,
**dadurch gekennzeichnet, daß** die Verbindung wenigstens eine in dem Leiterplatten-Substrat (10) und in dem prepreg (30) angeordnete Entlüftungsbohrung (60) ist.

2. Verfahren nach Anspruch 1, **dadurch gekennzeichnet, daß** der Preßstempel (70) im Bereich (12) der Öffnung (11) eine Aussparung (71) aufweist.

3. Verfahren nach Anspruch 1, **dadurch gekennzeichnet, daß** zwischen den Preßstempel (70) und das Leiterplatten-Substrat (10) eine Preßeinlage (80) gelegt wird, die im Bereich (12) der Öffnung (11) eine Ausnehmung (81) aufweist.

4. Verfahren nach einem der voranstehenden Ansprüche, **dadurch gekennzeichnet, daß** zusätzlich im Bereich (12) der Öffnung (11) in dem prepreg (30) eine Aussparung vorgesehen ist.

5. Verfahren nach Anspruch 4, **dadurch gekennzeichnet, daß** die in dem Träger (40) angeordnete Ausnehmung (42) an die Toleranzen des Leiterplatten-Substrates (10) und an in der Öffnung angeordnete Steckerpins Anschlußdrähte (60) u.dgl. angepaßt wird.

6. Verfahren nach Anspruch 1, **dadurch gekennzeichnet, daß** der Preßstempel (70) im Bereich (12) der Öffnung (11) eine Aussparung (71) aufweist und daß zusätzlich in dem Träger (40) im Bereich (12) der Öffnung (11) eine auf die Aussparung (71) angepaßte Ausnehmung (43) und eine Verbindung der Ausnehmung (43) mit der Umgebung vorgesehen ist.

7. Verfahren nach Anspruch 1, **dadurch gekennzeichnet, daß** zwischen den Preßstempel (70) und das Leiterplatten-Substrat (10) eine Preßeinlage (80) gelegt wird, die im Bereich (12) der Öffnung (11) eine Ausnehmung (81) aufweist und daß zusätzlich in dem Träger (40) im Bereich (12) der Öffnung (11) eine auf die Ausnehmung (81) in der Preßeinlage (80) angepaßte Ausnehmung (44) und eine Verbindung der Ausnehmung (44) mit der Umgebung vorgesehen sind.

8. Verfahren nach Anspruch 6 oder 7, **dadurch gekennzeichnet, daß** zusätzlich im Bereich (12) der Öffnung (11) in dem prepreg (30) eine Aussparung vorgesehen ist.

## Claims

1. Process for manufacturing a composite arrangement, at least one printed circuit board substrate (10) being bonded to a carrier via a resin-impregnated layer of woven fabric (prepreg, 30) under the effect of pressing pressure exerted by a pressing stamp (70), the pressing pressure (p) being at least partially reduced in the region (12) of an opening (11) in the printed circuit board substrate (10) and a recess (42) and a connection of the recess (42) to the surroundings being provided in the carrier (40) in the region (12) of the opening (11), **characterized in that** the connection is at least one venting bore (60) arranged in the printed circuit board substrate (10) and in the prepreg (30).

2. Process according to Claim 1, **characterized in that** the pressing stamp (70) has a clearance (71) in the region (12) of the opening (11).

3. Process according to Claim 1, **characterized in that** a pressing insert (80), which has a recess (81) in the region (12) of the opening (11), is placed between the pressing stamp (70) and the printed circuit board substrate (10).

4. Process according to one of the preceding claims, **characterized in that** a clearance is additionally provided in the prepreg (30) in the region (12) of the opening (11).

5. Process according to Claim 4, **characterized in that** the recess (42) arranged in the carrier (40) is adapted to the tolerances of the printed circuit board substrate (10) and to the plug pins, terminal wires (60) and the like arranged in the opening.

6. Process according to Claim 1, **characterized in that** the pressing stamp (70) has a clearance (71) in the region (12) of the opening (11) and **in that** a recess (43) adapted to the clearance (71) and a connection of the recess (43) to the surroundings are additionally provided in the carrier (40) in the region (12) of the opening (11).

7. Process according to Claim 1, **characterized in that** a pressing insert (80), which has a recess (81) in the region (12) of the opening (11), is placed between the pressing stamp (70) and the printed circuit board substrate (10) and **in that** a recess (44) adapted to the recess (81) in the pressing insert (80) and a connection of the recess (44) to the surroundings are additionally provided in the carrier (40) in the region (12) of the opening (11).

8. Process according to Claim 6 or 7, **characterized in that** a clearance is additionally provided in the prepreg (30) in the region (12) of the opening (11).

## Revendications

1. Procédé de réalisation d'un agencement composite selon lequel on relie au moins un substrat de plaque de circuit 10 sous l'action d'une pression exercée par un poinçon de presse 70 à une couche de tissu imprégnée de résine (prepreg) 30, pour la relier à un support, selon lequel
au niveau 12 d'une ouverture 11 du substrat de plaque de circuit 10, on réduit au moins partiellement la pression (p) et dans la zone 12 de l'ouverture 11, le support 40, a une cavité 42 en liaison avec l'environnement,
**caractérisé en ce que**
la liaison est un perçage de ventilation 60 dans le substrat de plaque de circuit 10 et dans la couche prepreg 30.

2. Procédé selon la revendication 1,
**caractérisé en ce que**
le poinçon de presse 70 comporte une cavité 71 dans la zone 12 de l'ouverture 11.

3. Procédé selon la revendication 1,
**caractérisé par**
un insert de presse 80 comportant une cavité 81 dans la zone 12 de l'ouverture 11 entre le poinçon de presse 70 et le substrat de plaque de circuit 10.

4. Procédé selon l'une des revendications précédentes,
**caractérisé en ce qu'**
en plus, dans la zone 12 de l'ouverture 11, la couche prepreg 30 comporte une cavité.

5. Procédé selon la revendication 4,
**caractérisé en ce que**
la cavité 42 prévue dans le support 40 est adaptée aux tolérances du support de plaque de circuit 10 et aux fils de branchement 60 ou analogues prévus sur des broches d'enfichage dans l'ouverture.

6. Procédé selon la revendication 1,
**caractérisé en ce que**
le poinçon de presse 70 présente une cavité 71 dans la zone 12 de l'ouverture 11 et en plus, dans le support 40, dans la zone 12 de l'ouverture 11, il est prévu une cavité 43 adaptée à la cavité 71 et une liaison de la cavité 43 avec l'environnement.

7. Procédé selon la revendication 1,
**caractérisé en ce qu'**
entre le poinçon de presse 70 et le substrat de plaque de circuit 10, il est prévu un insert de presse 80 qui comporte une cavité 81 au niveau 12 de l'ouverture 11 et **en ce qu'**en plus, dans le support 40, dans la zone 12 de l'ouverture 11, il y a une cavité 43 adaptée à la cavité 81 de l'insert de presse 80 et une liaison de la cavité 44 avec l'air ambiant.

8. Procédé selon les revendications 6 ou 7,
**caractérisé par**
une cavité en plus, dans la zone 12 de l'ouverture 11 dans la couche prepreg 30.
